(19) Europäisches Patentamt
European Patent Office
Office européen des brevets

(11) Veröffentlichungsnummer : **0 048 876**
**B1**

(12) # EUROPÄISCHE PATENTSCHRIFT

(45) Veröffentlichungstag der Patentschrift : **11.04.84**

(51) Int. Cl.³ : **G 03 C 1/70**, G 03 C 5/36, G 03 C 5/18, G 03 F 7/08

(21) Anmeldenummer : **81107212.3**

(22) Anmeldetag : **12.09.81**

(54) **Lichthärtbares Gemisch und damit hergestelltes lichtempfindliches Kopiermaterial.**

(30) Priorität : **25.09.80 DE 3036077**

(43) Veröffentlichungstag der Anmeldung : **07.04.82 Patentblatt 82/14**

(45) Bekanntmachung des Hinweises auf die Patenterteilung : **11.04.84 Patentblatt 84/15**

(84) Benannte Vertragsstaaten : **AT BE CH DE FR GB IT LI NL SE**

(56) Entgegenhaltungen : **Keine**

(73) Patentinhaber : **HOECHST AKTIENGESELLSCHAFT
Postfach 80 03 20
D-6230 Frankfurt am Main 80 (DE)**

(72) Erfinder : **Bosse, Dieter, Dr.
Berliner Strasse 12
D-6238 Hofheim/Ts. (DE)**
Erfinder : **Frass, Werner, Dr.
Erbsenacker 37
D-6200 Wiesbaden (DE)**

**EP 0 048 876 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

# Lichthärtbares Gemisch und damit hergestelltes lichtempfindliches Kopiermaterial

Die Erfindung betrifft ein negativ arbeitendes lichthärtbares Gemisch, das als lichtempfindliche Verbindung ein Diazoniumsalz-Polykondensationsprodukt oder eine organische Azidoverbindung und als Bindemittel ein hochmolekulares Polymeres mit seitenständigen Sulfonylurethangruppen, das in wäßrig-alkalischer Lösung löslich oder quellbar ist, enthält und vorzugsweise zur Herstellung von Druckplatten verwendet wird.

Gemische der angegebenen Gattung sind in der DE-A-20 53 363 beschrieben. Sie enthalten als Bindemittel ein Umsetzungsprodukt aus mindestens einem Alkyl-, Alkoxy-, Aryl- oder Aryloxysulfonylisocyanat und einem Hydroxygruppen enthaltenden Polymeren. Jedoch lassen sich Schichten, die Diazoniumsalz-Polykondensate und derartige Polymere als Bindemittel enthalten, nur dann entwickeln, wenn den dort beschriebenen alkalischen Entwicklern vom pH-Bereich 7,5-9,5 organische Lösungsmittel zugesetzt werden. Die für diese Zwecke geeigneten, zumeist niedrig siedenden organischen Lösungsmittel können beim Anwender ohne ausreichende Absaugung der Dämpfe neben der Geruchsbelästigung auch zu gesundheitlichen Schäden führen. Die Beseitigung der verbrauchten Entwickler ist nicht ohne Einhaltung besonderer Vorsichtsmaßnahmen möglich.

Ähnliche Polymere wie die zuvor genannten Bindemittel mit seitenständigen Sulfonylurethangruppen sind in der DE-A-20 53 364 beschrieben. Diese Polymeren enthalten in den seitenständigen Sulfonylurethangruppen endständige ungesättigte Reste und werden als lichtvernetzbare Stoffe, gegebenenfalls in Kombination mit niedermolekularen polymerisierbaren Verbindungen eingesetzt. Als polymere Bindemittel für Schichten auf Basis anderer lichtempfindlicher Systeme, wie Diazo- oder Azidoverbindungen, hat man diese Polymeren nicht verwendet, offenbar weil man bei Kombination zweier nach einem unterschiedlichen Mechanismus lichthärtbarer Bestandteile unkontrollierbare Lichtreaktionen und insbesondere Dunkelreaktionen befürchten mußte. So wird z. B. in der DE-A-2 053 364, Seite 7, Zeilen 6-9, ausgeführt, daß die dort beschriebenen Verbindungen wesentlich weniger zu unerwünschten Vernetzungen neigen als Verbindungen mit seitenständigen Acryl- oder Methacrylsäuregruppen. Da diese Neigung zum Unterschied von gesättigten Bindemitteln jedoch stets vorhanden ist und gegebenenfalls in Gegenwart thermolabiler Verbindungen wie Diazo- oder Azidoverbindungen verstärkt werden kann, hat man bisher derartige Kombinationen vermieden.

Aufgabe der Erfindung war es, lichtempfindliche Gemische der angegebenen Gattung vorzuschlagen, die leichter und sicherer durch Anwendung eines lösungsmittelfreien, umweltfreundlichen Entwicklers zu entwickeln sind als bekannte Gemische, in übrigen aber die wünschenswerten Eigenschaften der bekannten Kopiermaterialien aufweisen.

Gegenstand der Erfindung ist ein lichthärtbares Gemisch, das als lichtempfindliche Verbindung ein Diazoniumsalz-Polykondensationsprodukt oder eine Azidoverbindung und als Bindemittel ein hochmolekulares Polymeres mit seitenständigen Sulfonylurethangruppen, das in wäßrigalkalischer Lösung löslich oder mindestens quellbar ist, enthält, und das dadurch gekennzeichnet ist, daß das Polymere seitenständige Alkenylsulfonyl- oder Cycloalkenylsulfonylurethangruppen enthält.

Erfindungsgemäß wird ferner ein lichtempfindliches Kopiermaterial für die Herstellung von Druckplatten vorgeschlagen, das aus einem Schichtträger und einer lichthärtbaren Schicht besteht, die als lichtempfindliche Verbindung ein Diazoniumsalz-Polykondensationsprodukt oder eine organische Azidoverbindung und als Bindemittel ein hochmolekulares Polymeres mit seitenständigen Sulfonylurethangruppen, das in wäßrig-alkalischer Lösung löslich oder mindestens quellbar ist, enthält, und das dadurch gekennzeichnet ist, daß das Polymere seitenständige Alkenylsulfonyl- oder Cycloalkenylsulfonylurethangruppen enthält.

Die in dem erfindungsgemäßen Gemisch enthaltenen ungesättigten Sulfonylurethane sind Umsetzungsprodukte von polymeren Substanzen, die Einheiten mit freien Hydroxygruppen enthalten, und Sulfonylisocyanaten der allgemeinen Formel

$$R{-}SO_2NCO,$$

worin R ein aliphatischer oder cycloaliphatischer Rest mit mindestens einer Doppelbindung ist.

Der Rest R enthält im allgemeinen 2 bis 12 Kohlenstoffatome und eine oder zwei, bevorzugt eine, olefinische Doppelbindungen. Wenn R eine Alkenylgruppe ist, hat diese bevorzugt 2 bis 4 Kohlenstoffatome; als Cycloalkenylgruppen werden solche mit 5 bis 8 Kohlenstoffatomen bevorzugt. Beispiele sind Vinyl-, Propenyl-, Allyl-, 1-Butenyl-(4)-, Cyclohex-3-en-1-yl-, Cyclohex-1-en-yl-, Methyl-cyclohex-3-en-1-yl und dgl. mehr. Besonders bevorzugt werden Propenyl- und Cyclohexenyl-Reste.

Die in dem erfindungsgemäßen Gemisch enthaltenen Polymeren enthalten an die Schlüsselatome, welche im Ausgangspolymeren die Hydroxygruppen getragen haben, gebunden die Gruppierung

$$-O{-}CONH{-}SO_2{-}R,$$

in der das am Stickstoff stehende Wasserstoffatom durch die Carbonyl- und die Sulfonylgruppe so stark aktiviert ist, daß es mit wäßrigem Alkali als Proton abgespalten werden kann, wodurch sich die Entwickelbarkeit mit wäßrig-alkalischen Entwicklern ergibt.

Es zeigte sich nun das überraschende Ergebnis, daß die oben beschriebenen ungesättigten Sulfonylurethane in Kombination mit Diazoniumsalz-Polykondensationsprodukten Schichten ergeben, die sich leicht und sauber mit rein wäßrigen Entwicklerlösung entwickeln lassen, während entsprechende Schichten mit gesättigten Sulfonylurethanpolymeren gemäß Beispiel 16 der DE-A-20 53 363 mindestens einen kleinen Anteil und bevorzugt fast 50 % organisches Lösungsmittel im Entwickler erfordern. Es zeigte sich weiterhin, daß überraschenderweise die Lagerfähigkeit der Kopiermaterialien mit ungesättigten Sulfonylurethanen nicht bemerkenswert schlechter ist als die von entsprechenden Materialien mit gesättigten Sulfonylurethanen.

Die in dem erfindungsgemäßen Gemisch verwendeten polymeren ungesättigten Sulfonylurethane sind, wie bereits erwähnt, aus der DE-A-20 53 364 an sich bekannt.

Als Hydroxygruppen enthaltende Ausgangspolymere für die Herstellung der polymeren ungesättigten Sulfonylurethane können Verwendung finden :

partiell verseifte Polyvinylester,
Polyvinylacetate mit unumgesetzten Vinylalkoholeinheiten,
Epoxid-Harze mit freien OH-Gruppen,
Cellulosepartialester und -ether und
Terpolymere aus Polyvinylchlorid, Polyvinylacetat und Polyvinylalkohol.

Besonders geeignet zur Herstellung der Bindemittel sind Polyvinylbutyrale und -formale mit freien OH-Gruppen, die handelsüblich sind.

Die für die Herstellung der erfindungsgemäß verwendeten Bindemittel notwendigen Sulfonylisocyanate sind in der DE-C-12 97 601 beschrieben.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenoläthern, aromatischen Thioäthern, aromatischen Kohlenwasserstoffen, aromatischen Heterocyclen und organischen Säureamiden, abgeleitet sind. Diese Kondensationsprodukte sind in der DE-A-20 24 244 beschrieben. Allgemein sind alle Diazoniumsalz-Polykondensationsprodukte geeignet, die in der DE-A-27 39 774 beschrieben sind.

Die Diazoniumsalzeinheiten leiten sich bevorzugt von Verbindungen der Formel $(R^1{-}R^3{-})_pR^2{-}N_2X$ ab, wobei

X das Anion der Diazoniumverbindung,

p eine ganze Zahl von 1 bis 3,

$R^1$ einen aromatischen Rest mit mindestens einer zur Kondensation mit aktiver Carbonylverbindung befähigten Position,

$R^2$ eine Phenylengruppe,

$R^3$ eine Einfachbindung oder eine der Gruppen :

$-(CH_2)_q-NR^4-$,
$-O-(CH_2)_r-NR^4-$,
$-S-(CH_2)_r-NR^4-$,
$-S-CH_2CO-NR^4-$,
$-O-R^5-O-$,
$-O-$
$-S-$ oder
$-CO-NR^4-$

bedeuten, worin

q eine Zahl von 0 bis 5,

r eine Zahl von 2 bis 5,

$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und

$R^5$ eine Arylengruppe mit 6 bis 12 C-Atomen ist.

Als lichtempfindliche Verbindungen sind weiter nieder- oder hochmolekulare organische Azide, insbesondere jedoch niedermolekulare aromatische Azidoverbindungen, die mindestens zwei Azidogruppen enthalten, geeignet. Beispiele für geeignete Verbindungen sind die folgenden :

4,4'-Diazido-stilben,
4,4'-Diazido-stilben-2,2'-disulfonsäure,
4,4'-Diazido-benzophenon,
4,4'-Diazido-diphenylmethan,
4,4'-Diazido-dibenzalaceton,

4,4'-Diazido-dibenzalaceton-disulfonsäure,
1,3-Bis-(4-azido-phenyl)-propan-2-on,
1,2-Bis-(4-azido-cinnamoyloxy) äthan,
4,4'-Diazido-benzalcyclohexanon,
4,4'-Diazido-benzalcyclohexanon-disulfonsäure,
2,6-Bis-(4-azido-benzal)-4-methyl-cyclohexanon.

Weitere Beispiele sind die in der GB-A-790 131 genannten Azidostyrylverbindungen, die in der DE-C-950 618 genannten Azido-imidazolylverbindungen und die in der US-A-2 848 328 genannten Diazidostilbenverbindungen.

Die erfindungsgemäßen Gemische enthalten im allgemeinen 5 bis 90, bevorzugt 10 bis 70 Gew.-% Diazoniumverbindung oder Azidoverbindung und 95 bis 10, bevorzugt 90 bis 30 Gew.-% des oben beschriebenen Bindemittels, bezogen auf das Gewicht aller nichtflüchtigen Bestandteile des Gemischs.

Zur Stabilisierung des lichtempfindlichen Gemischs ist es vorteilhaft, diesem eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure.

Den Gemischen können ferner Weichmacher, Haftvermittler, Farbstoffe, Pigmente, Farbbildner und andere Harze zugesetzt werden.

Art und Menge dieser Zusätze richten sich nach dem für das erfindungsgemäße Gemisch vorgesehenen Anwendungsgebiet. Dabei ist grundsätzlich zu beachten, daß die beigefügten Stoffe keinen übergroßen Anteil des für die Vernetzung notwendigen aktinischen Lichts absorbieren und dadurch die praktische Lichtempfindlichkeit herabsetzen.

Die lichtempfindlichen Gemische können ferner Farbstoffe und/oder Pigmente enthalten, die sowohl als Kontrastmittel als auch schichtverfestigend wirken können. In Frage kommende Farbstoffe sind beispielsweise in den US-Patentschriften 3 218 167 und 3 884 693 angegeben.

Besonders geeignet sind z. B. Viktoriareinblau FGA, Viktoriareinblau BO (C.I. 42595), Malachitgrün, Kristallviolett, Viktoriablau B (C.I. 44045), Rhodamin 6 GDN (C.I. 45160), Fettrot 5B (C.I. 26125), Neozapon Blau FLE (C.I. Solvent Blue 70), Brilliantblausalz-Acetat, Samaronmarineblau, Orasolblau GN, Renolblau B 2 G (C.I. 74160), Zaponechtfeuerrot B (C.I. 13900 : 1).

Zur Erhöhung des Bildkontrastes nach dem Belichten können Metanilgelb (C.I. 13065), Methylorange (C.I. 13025) oder Phenylazodiphenylamin verwendet werden.

Im Rahmen der Erfindung wird folgende gewichtsmäßige Verteilung der wichtigsten Zusätze in dem lichtempfindlichen Gemisch bevorzugt, bezogen auf den Gehalt an nichtflüchtigen Bestandteilen, d. h. die Bestandteile der nach dem Verdampfen des Lösungsmittels erhaltenen festen lichtempfindlichen Schicht.

| | |
|---|---|
| Säure | 0 bis 5 % |
| Farbstoff oder Pigment | 0 bis 10 % |
| Belichtungskontrastgeber (Farbstoff) | 0 bis 10 % |

Die erfindungsgemäßen lichtempfindlichen Gemische können gewerblich in Form einer Lösung oder Dispersion, z. B. als sogenannter Kopierlack, verwendet werden, die vom Verbraucher selbst auf einen individuellen Träger, wie beispielsweise für das Formteilätzen, für die Herstellung kopierter Schaltungen bzw. Schablonen, Beschilderungen, Siebdruckformen und dgl. gebräuchlich, aufgebracht und nach dem Trocknen belichtet und bildmäßig entwickelt werden. In diesem Falle werden die Bestandteile des lichtempfindlichen Gemischs in einem geeigneten Lösungsmittel gelöst. Als Lösungsmittel sind Alkohole, Ketone, Ester und Ether und dgl. geeignet. Als günstige Lösungsmittel haben sich dabei die Partialether der Glykole oder der Ketoalkohole erwiesen, z. B. Ethylenglykolmonomethylether.

Das erfindungsgemäße lichtempfindliche Gemisch kann insbesondere aber auch in Form einer festen, auf einem Trägermaterial befindlichen, lichtempfindlichen Schicht für die Herstellung von Druckformen, Reliefbildern, Ätzreserven, Schablonen, Matern, Siebdruckformen, Einzelkopien und dgl. in den Handel gebracht werden. Eine besonders wichtige Anwendung bilden lagerfähige vorsensibilisierte Druckplatten für den Flachdruck.

Die Beschichtung des Trägermaterials erfolgt aus entsprechenden organischen Lösungsmitteln oder Lösungsmittelgemischen, und zwar durch Gießen, Sprühen oder Eintauchen.

Als Schichtträger eignen sich z. B. Magnesium, Zink, Kupfer, mechanisch, chemisch und elektrochemisch aufgerauhtes Aluminium, anodisiertes Aluminium, Stahl, aber auch Polyester- oder Celluloseacetatfolie, Perlongaze etc., deren Oberfläche bei Bedarf einer Vorbehandlung unterworfen sein kann. Das Trägermaterial kann dabei als endgültiger Schichtträger fungieren oder als temporäres Trägermaterial, von dem die lichtempfindliche Schicht auf das zu bearbeitende Werkstück mittels Laminieren übertragen wird.

Das mit den lichtempfindlichen Gemischen hergestellte Aufzeichnungsmaterial dient einerseits zur Herstellung von Bildern auf geeigneten Trägern bzw. Empfangsblättern, andererseits zur Herstellung von Reliefs, die als Druckformen, Siebe, Reservagen und dgl. Anwendung finden.

Darüber hinaus ist es aber auch möglich, die lichtempfindlichen Gemische zur Herstellung von durch UV-Strahlung härtbaren Lacken zu verwenden, die als Oberflächenschutz eingesetzt werden können, oder zur Formulierung von UV-härtbaren Druckfarben.

Besonders bevorzugt wird das Gemisch zur Herstellung von Flachdruckformen verwendet, wobei als Trägermaterial Aluminium bevorzugt wird.

Besonders bevorzugt wird Aluminium, das für diesen Zweck in üblicher Weise vorbehandelt wird, z. B. durch mechanisches, chemisches oder elektrochemisches Aufrauhen und ggf. anschließende anodische Oxidation. Eine weitere Behandlung dieses Trägermaterials, z. B. mit Polyvinylphosphonsäure, Alkalisilikat, Phosphat, Hexafluorzirkonat, Chromat, Borat, Polyacrylamid und Cellulosederivaten, ist vorteilhaft.

Die Verarbeitung der aus den Gemischen erhaltenen Kopiermaterialien erfolgt in bekannter Weise durch bildmäßiges Belichten und Auswaschen der unbelichteten Schichtbereiche mit einem geeigneten Entwickler.

Die Belichtung des Kopiermaterials erfolgt in bekannter Weise unter einer Vorlage mit Kopierlichtquellen, die einen möglichst hohen Spektralanteil im nahen Ultraviolettbereich emittieren. Sie kann auch durch Laserbestrahlung erfolgen. Geeignet für die Bestrahlung sind leistungsgerechte kürzerwellige Laser, beispielsweise Ar-Laser, Krypton-Ionen-Laser, Helium/Cadmium-Laser, die etwa zwischen 300 und 600 nm emittieren, aber für einige Schichten auch $CO_2$-Laser, welche bei 10,6 µm emittieren, oder YAG-Laser, die bei 1,06 µm emittieren.

Als Entwicklerlösungen werden wäßrig-alkalische Lösungen mit einem pH-Wert im Bereich von 8 bis 14, vorzugsweise 10 bis 13, verwendet, die Puffersalze, z. B. wasserlösliche Alkaliphosphate, -silikate, -borate, -carbonate, -acetate oder -benzoate, enthalten. Als weitere Bestandteile werden Netzmittel, vorzugsweise anionische Netzmittel, und ggf. wasserlösliche Polymere verwendet. Obwohl die erfindungsgemäßen Kopiermaterialien vorzugsweise mit rein wäßrigen Entwicklern verarbeitet werden, kann es in bestimmten Fällen, z. B. bei Kombination mit wenig wasserlöslichen lichtempfindlichen Verbindungen oder bei Zusatz von alkaliunlöslichen Harzen zu dem lichtempfindlichen Gemisch, zweckmäßig sein, kleine Mengenanteile, d. h. weniger als 10 Gew.-%, vorzugsweise weniger als 5 Gew.-% an organischen, mit der Lösung mischbaren Lösungsmitteln zuzusetzen. Die Entwicklung kann in bekannter Weise durch Tauchen, Besprühen, Bürsten oder Tamponieren erfolgen.

Die erfindungsgemäßen lichtempfindlichen Gemische bzw. Schichten zeigen folgende Vorteile :

Sie besitzen hohe praktische Lichtempfindlichkeit, scharfe Differenzierungsmöglichkeiten zwischen Bild- und Nichtbildstellen, hohes Auflösungsvermögen, leichte schleierfreie Aufentwicklung, hohe Druckauflagen, gute Verträglichkeit der Schichtbestandteile in den zur Beschichtung geeigneten Lösungsmitteln, z. B. Ethylenglykolmonomethylether, Ethylenglykolmonoethylether, Diacetonalkohol, sowie Gemische der genannten Lösungsmittel mit Butylacetat, Ethylenglykolmethyletheracetat und Methylisobutylketon, leichte Entwickelbarkeit in lösungsmittelfreien wäßrigen Entwickler-Lösungen.

Die folgenden Beispiele sollen die Erfindung erläutern. Gewichtsteile und Volumteile stehen im Verhältnis von g/ccm, Prozentangaben und Mengenverhältnisse sind in Gewichtseinheiten zu verstehen, wenn nichts anderes angegeben ist.

## Beispiel 1

11,3 Gt eines Polyvinylburyrals mit einem Molekulargewicht von etwa 70-80 000, das 71 Gew.-% Vinylbutyral-, 2 Gew.-% Vinylacetat- und 27 Gew.% Vinylalkohol-Einheiten enthielt, wurden in 170 Gt wasserfreiem Tetrahydrofuran gelöst. Zu der klaren Lösung wurde bei Raumtemperatur eine Mischung aus 5,11 Gt Propenylsulfonylisocyanat und 30 Gt Tetrahydrofuran innerhalb von 15 Minuten zugetropft. Die Innentemperatur stieg dabei von ca. 25 °C auf ca. 31 °C an. Die Lösung wurde 4 Stunden bei Raumtemperatur nachgerührt und anschließend in 5 000 Vt Wasser eingetropft. Das erhaltene weiße, faserige Produkt wurde abgesaugt und getrocknet.

Die Ausbeute betrug 16,4 Gt Polymeres, das einen Erweichungspunkt von ca. 161 °C und eine Säurezahl von 81,0 hatte.

Eine Beschichtungslösung wurde aus

97,0 Gt des oben beschriebenen Bindemittels,
48,3 Gt eines Diazoniumsalz-Polykondensationsproduktes, hergestellt aus 1 Mol 3-Methoxydiphenylamin-4-diazoniumsulfat und 1 Mol 4,4'-Bis-methoxymethyl-diphenylether in 85 %iger Phosphorsäure und isoliert als Mesitylensulfonat,
4,8 Gt Phosphorsäure (85 %),
3,5 Gt Viktoriareinblau FGA (C.I. Basic Blue 81) und
1,6 Gt Phenylazodiphenylamin in
3 500 Gt Ethylenglykolmonomethylether und
1 036 Gt Tetrahydrofuran

hergestellt.

Die Lösung wurde auf eine Aluminiumfolie, die durch Bürsten mit einer wäßrigen

Schleifmittelsuspension aufgerauht und danach mit einer 0,1 %igen wäßrigen Lösung von Polyvinylphosphonsäure vorbehandelt worden war, aufgebracht und getrocknet.

Die Kopierschicht wurde unter einer Negativvorlage 35 Sekunden lang mit einer Metallhalogenid-Lampe von 5 kW Leistung belichtet.

Die belichtete Schicht wurde mit einer Entwickler-Lösung folgender Zusammensetzung

5 Gt Natriumlaurylsulfat,
1,5 Gt Natriummetasilikat × 5 $H_2O$,
1 Gt Trinatriumphosphat × 12 $H_2O$,
92,5 Gt Wasser

mittels eines Plüschtampons behandelt, wobei die nichtbelichteten Schichtbereiche entfernt wurden, dann mit Wasser abgespült und abgetrocknet. In der Kopie war die Stufe 5 eines Silberfilm-Halbtonstufenkeils mit einem Dichteumfang von 0,05 bis 3,05, wobei die Dichteinkremente 0,15 betrugen, noch voll geschwärzt.

Die erhaltene Druckplatte lieferte an einer Bogenoffset-Maschine eine Auflage von 30 000 Bögen.

Beispiel 2

22,6 Gt des in Beispiel 1 beschriebenen Polyvinylbutyrals und 20,45 Gt Propenylsulfonyl-isocyanat wurden wie in Beispiel 1 angegeben umgesetzt. Nach dem Ausfällen in Wasser wurde ein weißes, faseriges Material mit der Säurezahl 144,1 erhalten.

Eine Beschichtungslösung wurde aus

30,3 Gt des oben beschriebenen Umsetzungsproduktes,
15,1 Gt des in Beispiel 1 beschriebenen Diazoniumsalz-Polykondensationsproduktes,
1,0 Gt Phosphorsäure (85 %),
1,1 Gt Viktoriareinblau FGA (C.I. Basic Blue 81) und
1,1 Gt Phenylazodiphenylamin in
1 600 Gt Ethylenglykolmonomethylether

bereitet.

Die Lösung wurde auf eine elektrochemisch aufgerauhte und anodisierte Aluminiumfolie, die mit Polyvinylphosphonsäure nachbehandelt worden war, aufgebracht. Das Schichtgewicht betrug nach dem Trocknen 0,8 g/m$^2$.

Die Verarbeitung wurde, wie im Beispiel 1 beschrieben, durchgeführt. Dabei wurde die Offsetplatte nach bildmäßiger Belichtung eine Minute in den Entwickler getaucht und anschließend mit Wasser abgebraust. Die Schicht war einwandfrei entwickelt, d. h. daß auch sehr kleine Raster- und Strichelemente stark differenziert abgebildet waren, keine Schleier oder Schichtreste auf Nichtbildstellen vorhanden waren und eine hohe Auflösung erreicht wurde.

Beispiel 3

Eine Beschichtungslösung wurde aus

34,1 Gt des in Beispiel 2 beschriebenen polymeren Umsetzungsproduktes,
11,4 Gt des in Beispiel 1 beschriebenen Diazoniumsalz-Polykondensationsproduktes,
0,5 Gt Phosphorsäure (85 %),
1,1 Gt Metanilgelb (C.I. 13 065) und
1,5 Gt Viktoriablau B (C.I. 44 045) in
1 600 Gt Ethylenglykolmonomethylether

hergestellt.

Die Lösung wurde auf den in Beispiel 2 angegebenen Schichtträger aufgebracht.

Das Trockenschichtgewicht betrug 0,8 g/m$^2$. Die Verarbeitung wurde wie in Beispiel 1 beschrieben durchgeführt. Mit der so erhaltenen Druckform wurden an einer Bogenoffsetmaschine hohe Auflagen erzielt.

Beispiel 4

22,6 Gt des in Beispiel 1 angegebenen Polyvinylbutyrals und 4,09 Gt Propenylsulfonylisocyanat wurden wie in Beispiel 1 beschrieben umgesetzt.

Eine Beschichtungslösung wurde hergestellt aus :

48,4 Gt einer 6,26 %igen Lösung des oben beschriebenen Polymeren in Tetrahydrofuran,

1,51 Gt des in Beispiel 1 beschriebenen Diazopolykondensats,
0,15 Gt Phosphorsäure (85 %),
0,11 Gt Viktoriareinblau FGA (C.I. Basic Blue 81) in
140 Gt Ethylenglykolmonomethylether.

Die Lösung wurde auf den in Beispiel 2 beschriebenen Träger derart aufgetragen, daß nach dem Trocknen ein Schichtgewicht von 0,85 g/m$^2$ erhalten wurde.

Die belichtete Schicht wurde mit einer Entwickler-Lösung folgender Zusammensetzung :

5 Gt Natriumlaurylsulfat,
3 Gt Natriummetasilikat × 5 $H_2O$,
92 Gt Wasser

ähnlich wie im Beispiel 1 beschrieben behandelt. Die erhaltene Druckform gab an Bogenoffsetmaschinen mehr als 70 000 Drucke.

Beispiel 5

22,6 Gt des in Beispiel 1 angegebenen Polyvinylbutyrals und 26,02 Gt Cyclohex-3-en-1-yl-sulfonylisocyanat wurden wie in Beispiel 1 beschrieben umgesetzt.

Eine Beschichtungslösung wurde hergestellt aus

30,3 Gt des obigen Umsetzungsproduktes mit einer Säurezahl von 142,6,
15,1 Gt des in Beispiel 1 beschriebenen Diazoniumsalz-Polykondensats,
1,2 Gt Phosphorsäure (85 %),
1,1 Gt Phenylazodiphenylamin und
1,5 Gt Viktoriareinblau FGA (C.I. Basic Blue 81) in
1 600 Gt Ethylenglykolmonomethylether.

Die Lösung wurde auf den in Beispiel 2 beschriebenen Träger zu einem Trockenschichtgewicht von 0,8 g/m$^2$ aufgetragen. Nach bildmäßiger Belichtung unter einer UV-Lichtquelle wurde mit dem in Beispiel 4 genannten Entwickler behandelt.

Die erhaltene Druckform gab auf einer Heidelberger-GTO-Bogenoffsetdruckmaschine mehr als 80 000 gute Drucke.

Beispiel 6

22,6 Gt des in Beispiel 1 beschriebenen Polyvinylbutyrals und 27,97 Gt Methyl-cyclohex-3-en-1-yl-sulfonylisocyanat (Isomerengemisch aus 3- und 4-Methylverbindung) wurden wie in Beispiel 1 angegeben umgesetzt. Nach Ausfällen in Wasser wurde ein weißes flockiges Material mit der Säurezahl von 131,6 erhalten, das sich in 3 %iger wäßriger Ammoniaklösung glatt löst.

Eine Beschichtungslösung wurde aus

30,3 Gt des oben beschriebenen Polymeren,
15,1 Gt des in Beispiel 1 beschriebenen Diazopolykondensats,
1,2 Gt Phosphorsäure (85 %),
1,1 Gt Phenylazodiphenylamin und
1,5 Gt Viktoriareinblau FGA (C.I. Basic Blue 81) in
1 600 Gt Ethylenglykolmonomethylether

hergestellt und auf den in Beispiel 2 beschriebenen Träger aufgeschleudert, so daß das Schichtgewicht 0,8 g/m$^2$ betrug. Die Verarbeitung wurde wie in Beispiel 1 angegeben durchgeführt, jedoch wurde der Entwickler aus Beispiel 4 verwandt. Mit der so erhaltenen Druckform wurden an einer Bogenoffsetmaschine mehr als 60 000 gute Drucke erhalten.

Beispiel 7

11,3 Gt des in Beispiel 1 angegebenen Polyvinylbutyrals und 13,88 Gt Vinylsulfonylisocyanat wurden wie in Beispiel 1 beschrieben umgesetzt. Nach Ausfällen in Wasser wurden 19,3 g (77 % d. Th.) eines weißen, faserigen Materials der Säurezahl 183,9 erhalten.

Eine Beschichtungslösung wurde aus

30,3 Gt des oben beschriebenen Umsetzungsprodukts,
15,1 Gt des in Beispiel 1 angegebenen Diazopolykondensats,
1,0 Gt Phosphorsäure (85 %),
1,1 Gt Phenylazodiphenylamin und

1,5 Gt Viktoriareinblau FGA (C.I. Basic Blue 81) in
1 650 Gt Ethylenglykolmonomethylether

hergestellt.

Die Lösung wurde auf die in Beispiel 2 beschriebene Aluminiumfolie zu einem Trockenschichtgewicht von 0,7 g/m$^2$ aufgebracht.

Die Kopierschicht wurde unter einer Negativvorlage 70 Sekunden lang mit einer Metallhalogenid-Lampe belichtet und wie in Beispiel 1 beschrieben mit dem Entwickler aus Beispiel 4 behandelt.

Mit der so erhaltenen Druckform wurden an einer Bogenoffsetmaschine mehr als 40 000 gute Drucke erhalten.

## Beispiel 8

Eine Beschichtungslösung wurde hergestellt aus

26,75 Gt einer 8 %igen Lösung des in Beispiel 1 beschriebenen Umsetzungsprodukts in Tetrahydrofuran,
2,14 Gt 2,6-Bis-(4-azido-benzal)-4-methyl-cyclohexanon und
0,23 Gt Rhodamin 6 GDN extra (C.I. 45 160) in
100 Gt Ethylenglykolmonomethylether und
50 Gt Tetrahydrofuran.

Die Lösung wurde auf den in Beispiel 2 angegebenen Schichtträger aufgebracht. Das Trockenschichtgewicht betrug 0,73 g/m$^2$. Die Verarbeitung wurde wie in Beispiel 1 beschrieben durchgeführt. Mit der so erhaltenen Druckform wurden an einer Bogenoffsetmaschine hohe Auflagen erzielt.

## Beispiel 9

Eine Beschichtungslösung wurde aus

26,75 Gt einer 8,0 %igen Lösung des in Beispiel 1 beschriebenen Umsetzungsprodukts in Tetrahydrofuran,
2,14 Gt 2,6-Bis-(4-azido-benzal)-4-methyl-cyclohexanon und
0,23 Gt Viktoriareinblau FGA (C.I. Basic Blue 81) in
100 Gt Ethylenglykolmonomethylether und
50 Gt Tetrahydrofuran

hergestellt.

Die Lösung wurde auf den in Beispiel 2 angegebenen Träger derart aufgetragen, daß nach dem Trocknen ein Schichtgewicht von 0,7 g/m$^2$ erhalten wurde.

Nach dem Belichten unter einer Negativvorlage wurde mit einer Entwicklerlösung folgender Zusammensetzung

5 Gt Triethanolammoniumsalz des Laurylsulfats,
1 Gt Natriummetasilikat × 5 $H_2O$,
1,5 Gt Trinatriumphosphat ×12 $H_2O$,
92,5 Gt Wasser

entwickelt und durch Einfärben mit fetter Farbe druckfertig gemacht.

Mit der so erhaltenen Platte wurden an einer Heidelberger-GTO-Bogenoffsetmaschine viele Tausend gute Drucke erhalten.

## Beispiel 10

Eine Beschichtungslösung wurde aus

26,75 Gt einer 8,0 %igen Lösung des in Beispiel 1 beschriebenen Umsetzungsproduktes in Tetrahydrofuran,
2,14 Gt 2,6-Bis-(4-azido-benzal)-4-methyl-cyclohexanon,
0,23 Gt Rhodamin 6 GDN extra und
0,21 Gt 2-Benzoylmethylen-1-methyl-β-naphthothiazin in
100 Gt Ethylenglykolmonomethylether und
50 Gt Tetrahydrofuran

hergestellt.

Die Lösung wurde auf den in Beispiel 2 beschriebenen Träger aufgeschleudert. Das Trockenschichtgewicht betrug 0,75 g/m$^2$.

Die Kopierschicht wurde unter einer Negativvorlage 35 Sekunden lang mit einer Metallhalogenid-Lampe von 5 kW Leistung belichtet ; dabei entstand ein deutlich sichtbares dunkelrotes, positives Bild.

Die belichtete Schicht wurde mittels eines Plüschtampons mit einer Entwicklerlösung folgender Zusammensetzung

5 Gt Natriumlaurylsulfat,
1 Gt Natriummetasilikat × 5 $H_2O$,
94 Gt Wasser

behandelt, wobei die Nichtbildstellen entfernt wurden, dann mit Wasser abgespült und abgerakelt. In der Kopie war die Stufe 5 des in Beispiel 1 beschriebenen Silberfilm-Halbtonkeils noch voll geschwärzt.

Die erhaltene Druckplatte lieferte an einer Bogenoffset-Maschine eine Auflage von 170 000 Bogen.

## Beispiel 11

Eine Beschichtungslösung wurde hergestellt aus

26,75 Gt einer 8 %igen Lösung des in Beispiel 1 beschriebenen Umsetzungsprodukts in Tetrahydrofuran,
2,1 Gt 4,4'-Diazido-stilben-3,3'-disulfonsäure,
0,23 Gt Rhodamin 6 GDN extra und
50 Gt Ethylenglykolmonomethylether.

Die Lösung wurde auf den in Beispiel 2 angegebenen Schichtträger aufgebracht. Das Trockenschichtgewicht betrug 0,75 g/m$^2$. Die Verarbeitung wurde wie in Beispiel 1 beschrieben durchgeführt. Eingesetzt wurde ein Entwickler folgender Zusammensetzung.

5 Gt Natriumlaurylsulfat,
0,5 Gt Natriummetasilikat × 5 $H_2O$,
94,5 Gt Wasser.

An Bogenoffsetmaschinen wurden mit dieser Druckform hohe Auflagen erzielt.

## Beispiel 12

Eine Beschichtungslösung wurde hergestellt aus

54,35 Gt einer 8,34 %igen Lösung des in Beispiel 1 beschriebenen Umsetzungsprodukts in Tetrahydrofuran,
0,91 Gt des in Beispiel 1 beschriebenen Diazoniumsalz-Polykondensationsprodukts,
0,18 Gt Phosphorsäure (85 %),
0,06 Gt Phenylazodiphenylamin und
0,13 Gt Viktoriareinblau FGA in
150 Gt Ethylenglykolmonomethylether.

Die Lösung wurde auf elektrochemisch aufgerauhtes und anodisiertes Aluminium derart aufgetragen, daß nach dem Trocknen ein Schichtgewicht von 1,1 g/m$^2$ erhalten wurde.

Die Verarbeitung wurde ähnlich wie in Beispiel 1 beschrieben durchgeführt. Die erhaltene Druckform ergab an Bogenoffsetmaschinen Auflagen von mehr als 150 000 Drucken.

## Beispiel 13

22,6 Gt eines Terpolymerisats aus 91 % Vinylchlorid, 3 % Vinylacetat und 6 % Vinylalkohol, mit einem mittleren Molekulargewicht von 15 500 und einem Erweichungspunkt von 77 °C wurden wie in Beispiel 1 beschrieben mit 4,52 Gt Propenylsulfonylisocyanat umgesetzt. Das erhaltene Produkt hatte die Säurezahl 42,3.

Eine Beschichtungslösung wurde hergestellt aus

56,55 Gt einer 6,35 %igen Lösung des oben beschriebenen Umsetzungsproduktes in Tetrahydrofuran,
1,79 Gt des in Beispiel 1 beschriebenen Diazoniumsalz-Polykondensats,
0,18 Gt Phosphorsäure (85 %),

0,06 Gt Phenylazodiphenylamin und
0,13 Gt Viktoriareinblau FGA in
140 Gt Ethylenglykolmonomethylether.

Die Lösung wurde auf eine elektrochemisch aufgerauhte und anodisierte Aluminiumfolie, die mit Polyvinylphosphonsäure nachbehandelt worden war, aufgebracht. Das Schichtgewicht der lichtempfindlichen Schicht betrug nach dem Trocknen 1,0 g/m$^2$.

Die Verarbeitung wurde ähnlich wie in Beispiel 1 beschrieben durchgeführt.

An Bogenoffsetmaschinen wurden mit dieser Druckform gute Auflagen erhalten.

Beispiel 14

Eine Beschichtungslösung wurde aus

3,03 Gt des in Beispiel 1 beschriebenen Umsetzungsprodukts,
1,51 Gt eines Diazoniumsalz-Polykondensationsprodukts, hergestellt aus Paraformaldehyd und Diphenylamin-4-diazoniumchlorid in 85 %iger Phosphorsäure,
0,05 Gt Phosphorsäure (85 %),
0,15 Gt Kristallviolett und
0,11 Gt Phenylazodiphenylamin in
170 Gt Ethylenglykolmonomethylether

hergestellt.

Die Lösung wurde auf eine elektrochemisch aufgerauhte und anodisierte Aluminiumfolie derart aufgetragen, daß nach dem Trocknen ein Schichtgewicht von 0,3 g/m$^2$ erhalten wurde.

Die Verarbeitung wurde ähnlich wie in Beispiel 1 beschrieben durchgeführt.

Die erhaltene Druckform gab in Bogenoffsetmaschinen viele Tausend gute Drucke.

Beispiel 15

Eine Beschichtungslösung wurde hergestellt aus

16,0 Gt einer 8,0 %igen Lösung des in Beispiel 1 beschriebenen Umsetzungsprodukts in Tetrahydrofuran,
0,725 Gt des in Beispiel 1 beschriebenen Diazoniumsalz-Polykondensationsprodukts,
0,072 Gt Phosphorsäure (85 %),
0,01 Gt Phenylazodiphenylamin,
0,5 Gt Renolblau B2G-H (Pigment Blue 15 : 3, C.I. 74160),
86,6 Gt Ethylenglykolmonomethylether.

Die Lösung wurde auf eine elektrochemisch aufgerauhte und anodisierte Aluminiumfolie, die mit Polyvinylphosphonsäure nachbehandelt worden war, aufgebracht. Das Schichtgewicht der lichtempfindlichen Schicht betrug nach dem Trocknen 1,0 g/m$^2$.

Die Verarbeitung wurde ähnlich wie in Beispiel 1 beschrieben durchgeführt.

Auf Bogenoffsetmaschinen wurden mit dieser Druckform gute Auflagen erhalten.

Beispiel 16

Analog der in Beispiel 1 beschriebenen Umsetzung wurden

45,2 Gt eines Polyvinylbutyrals mit einem Molekulargewicht von über 80 000, das 77-80 Gew.-% Vinylbutyral-, 2 Gew.-% Vinylacetat- und 18-21 Gew.-% Vinylalkohol-Einheiten enthielt, in
580 Gt wasserfreiem Tetrahydrofuran gelöst und bei Raumtemperatur mit einer Lösung von
31,7 Gt Propenylsulfonylisocyanat in
60 Gt Tetrahydrofuran versetzt und 4 Stunden bei Raumtemperatur nachreagieren gelassen.

Eine Beschichtungslösung wurde aus

906,7 Gt einer 12 %igen Lösung des oben beschriebenen Bindemittels in Tetrahydrofuran,
10,88 Gt des in Beispiel 1 beschriebenen Diazoniumsalz-Polykondensationsproduktes,
1,08 Gt Phosphorsäure (85 %),
0,8 Gt Viktoriareinblau FGA,
0,36 Gt Phenylazodiphenylamin in
5 800 Gt Ethylenglykolmonomethylether,

2 500 Gt Tetrahydrofuran und
770 Gt Butylacetat

bereitet.

Die Lösung wurde auf eine elektrochemisch aufgerauhte und anodisierte Aluminiumfolie, die mit Polyvinylphosphonsäure nachbehandelt worden war, aufgebracht. Das Schichtgewicht betrug nach dem Trocknen 0,5 g/$m^2$.

Die Platte wurde mit Laserlicht eines Argon-Ionen-Lasers so belichtet, daß die Schicht einer Energie von 5 mJ/$cm^2$ ausgesetzt wurde.

Die belichtete Schicht wurde mit einem Emulsionslack entwickelt, der von der Firma Western Litho unter der Bezeichnung «Jet Black Medium» in den Handel gebracht wird.

Die erhaltene Druckplatte lieferte an einer Bogenoffset-Maschine eine Auflage von mehr als 40 000 Bögen.

## Ansprüche

1. Lichthärtbares Gemisch, das als lichtempfindliche Verbindung ein Diazoniumsalz-Polykondensationsprodukt oder eine organische Azidoverbindung und als Bindemittel ein hochmolekulares Polymeres mit seitenständigen Sulfonylurethangruppen, das in wäßrig-alkalischer Lösung löslich oder mindestens quellbar ist, enthält, dadurch gekennzeichnet, daß das Polymere seitenständige Alkenylsulfonyl- oder Cycloalkenylsulfonylurethangruppen enthält.

2. Lichthärtbares Gemisch nach Anspruch 1, dadurch gekennzeichnet, daß das Polymere das Umsetzungsprodukt aus einem Polymeren, das Einheiten mit freien Hydroxygruppen enthält, und einem Alkenyl- oder Cycloalkenylsulfonylisocyanat ist.

3. Lichthärtbares Gemisch nach Anspruch 2, dadurch gekennzeichnet, daß das Polymere, das Einheiten mit freien Hydroxygruppen enthält, ein partiell verseifter Polyvinylester, ein Polyvinylacetal mit unumgesetzten Vinylalkoholeinheiten, ein Epoxidharz, ein Cellulosepartialester oder -ether oder ein Terpolymeres aus Vinylchlorid-, Vinylacetat- und Vinylalkoholeinheiten ist.

4. Lichthärtbares Gemisch nach Anspruch 3, dadurch gekennzeichnet, daß das Polymere ein Polyvinylbutyral oder -formal mit unumgesetzten Vinylalkoholeinheiten ist.

5. Lichthärtbares Gemisch nach Anspruch 1, dadurch gekennzeichnet, daß das Diazoniumsalz-Polykondensationsprodukt aus wiederkehrenden Einheiten A—$N_2$X und B besteht, die durch Zwischenglieder, vorzugsweise Methylengruppen, verbunden sind, die von kondensationsfähigen Carbonylverbindungen, vorzugsweise Formaldehyd, abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenoläthers, aromatischen Thioäthers, aromatischen Kohlenwasserstoffs, aromatischen Heterocyclus oder eines organischen Säureamids ist.

6. Lichtempfindliches Kopiermaterial für die Herstellung von Druckplatten, bestehend aus einem Schichtträger und einer lichthärtbaren Schicht, die als lichtempfindliche Verbindung ein Diazoniumsalz-Polykondensationsprodukt oder eine organische Azidoverbindung und als Bindemittel ein hochmolekulares Polymeres mit seitenständigen Sulfonylurethangruppen, das in wäßrig-alkalischer Lösung löslich oder mindestens quellbar ist, enthält, dadurch gekennzeichnet, daß das Polymere seitenständige Alkenylsulfonyl- oder Cycloalkenylsulfonylurethangruppen enthält.

## Claims

1. A light-curable mixture which contains as the light-sensitive compound a diazonium salt polycondensation product or an organic azido compound and, as the binder, a high-molecular polymer which has sulfonylurethane side groups and which is soluble or at least swellable in an aqueous-alkaline solution, characterized in that the polymer contains alkenylsulfonylurethane or cycloalkenylsulfonylurethane side groups.

2. A light-curable mixture as claimed in Claim 1, wherein the polymer is the reaction product of a polymer, which contains units with free hydroxyl groups, and of an alkenylsulfonyl isocyanate or cycloalkenylsulfonyl isocyanate.

3. A light-curable mixture as claimed in Claim 2, wherein the polymer, which contains units with free hydroxyl groups, is a partially hydrolyzed polyvinyl ester, a polyvinyl acetal with unconverted vinyl alcohol units, an epoxide resin, a partial ester or ether of cellulose, or a terpolymer comprising units of vinyl chloride, vinyl acetate and vinyl alcohol.

4. A light-curable mixture as claimed in Claim 3, wherein the polymer is a polyvinyl butyral or polyvinyl formal with unconverted vinyl alcohol units.

5. A light-curable mixture as claimed in Claim 1, wherein the diazonium salt polycondensation product comprises recurring A—$N_2$X and B units which are linked by intermediate members, preferably

methylene groups, which are derived from carbonyl compounds capable of condensation, for example formaldehyde, A being the radical of an aromatic diazonium compound which is capable of condensation with formaldehyde, and B being the radical of a compound which is free from diazonium groups and capable of condensation with formaldehyde, in particular the radical of an aromatic amine, a phenol, phenol ether, aromatic thioether, aromatic hydrocarbon, aromatic heterocyclic compound or an organic acid amide.

6. A light-sensitive copying material for the preparation of printing plates, composed of a support and a light-curable layer which contains, as the light-sensitive compound, a diazonium salt polycondensation product or an organic azido compound and, as the binder, a high-molecular polymer which has sulfonylurethane side groups and which is soluble or at least swellable in an aqueous-alkaline solution, wherein the polymer contains alkenylsulfonylurethane or cycloalkenylsulfonylurethane side groups.

**Revendications**

1. Mélange durcissable à la lumière qui contient comme composé sensible à la lumière un produit de polycondensation de sel de diazonium ou un composé azido organique et comme liant un polymère de masse moléculaire élevée avec des groupes sulfonyluréthanne latéraux, qui est soluble ou au moins gonflable dans une solution alcaline aqueuse, caractérisé en ce que le polymère contient des groupes latéraux alcénylsulfonyluréthanne ou cycloalcénylsulfonyluréthanne.

2. Mélange durcissable à la lumière selon la revendication 1, caractérisé en ce que le polymère est le produit de réaction d'un polymère qui contient des unités avec des groupes hydroxy libres, et d'un alcényl- ou cycloalcénylsulfonylisocyanate.

3. Mélange durcissable à la lumière selon la revendication 2, caractérisé en ce que le polymère qui contient des unités avec des groupes hydroxy libres, est un ester de polyvinyle partiellement saponifié, un acétal polyvinylique avec des unités alcool vinylique n'ayant pas réagi, une résine époxyde, un ester ou un éther partiel de cellulose ou un terpolymère d'unités chlorure de vinyle, acétate de vinyle et alcool vinylique.

4. Mélange durcissable à la lumière selon la revendication 3, caractérisé en ce que le polymère est un butyral polyvinylique ou un formal polyvinylique avec des unités alcool vinylique n'ayant pas réagi.

5. Mélange durcissable à la lumière selon la revendication 1, caractérisé en ce que le produit de polycondensation de sel de diazonium consiste en des unités récurrentes $A—N_2X$ et B, qui sont reliées par des éléments intermédiaires, de préférence des groupes méthylène, qui proviennent de composés carbonyliques condensables, de préférence le formaldéhyde, A étant le reste d'un composé de diazonium aromatique condensable avec le formaldéhyde et B le reste d'un composé condensable avec le formaldéhyde, sans groupe diazonium, en particulier d'une amine aromatique, d'un phénol, d'un éther phénolique, d'un thioéther aromatique, d'un hydrocarbure aromatique, d'un hétérocycle aromatique ou d'un amide d'acide organique.

6. Matériau de reproduction sensible à la lumière pour la production de plaques d'impression, constitué d'un support de couche et d'une couche durcissable à la lumière qui contient comme composé sensible à la lumière un produit de polycondensation de sel de diazonium ou un composé azido organique et comme liant un polymère de masse moléculaire élevée avec des groupes sulfonyluréthanne latéraux, qui est soluble ou au moins gonflable dans une solution alcaline aqueuse, caractérisé en ce que le polymère contient des groupes latéraux alcénylsulfonyluréthanne ou cycloalcénylsulfonyluréthanne.